# EUROPEAN PATENT APPLICATION

(11) **EP 2 618 477 A1**
(43) Date of publication of application: **24.07.2013**
(21) Application number: 11814678.6
(22) Date of filing: 03.08.2011
(51) Int. Cl.: H02N 11/00, H01L 35/30

(54) **THERMOELECTRIC ELECTRICITY GENERATING DEVICE**

(30) Priority: 23.08.2010 JP 2010201371; 04.08.2010 JP 2010186610
(71) Applicant: Hokkaido Tokushu Shiryo Kabushiki Kaisha, Sapporo-shi, Hokkaido 060-0013 (JP)
(72) Inventor: ONOSE Kazuhiro, Kamikawa-gun Hokkaido 089-0100 (JP)
(74) Representative: Zech, Stefan Markus
(86) International application number: PCT/JP2011/067796
(87) International publication number: WO 2012/018053

(57) **Abstract**

Provided is a thermoelectric power generating apparatus that can generate power by thermoelectric conversion by efficiently utilizing a temperature difference produced in a thermal energy source. The apparatus 1 includes a high-temperature flow path 11, 12 through which a high-temperature heat transfer medium 2H flows, a low-temperature flow path 21, 22 through which a low-temperature heat transfer medium 2L flows, and a power generating layer 30-1, 30-2, 30-3 that generates power from a temperature difference. The high and low temperature flow paths 11, 12 and 21, 22, are each formed in a plurality of layers and alternately layered with each other with their centers in common. The power generating layer 30-1, 30-2, 30-3 is disposed between the high and low temperature flow paths 11, 12 and 21, 22 that are next to each other. Since the apparatus 1 generates power by thermoelectric conversion by multiple power generating layers 30-1, 30-2 and 30-3 sandwiched between the alternately disposed high and low temperature flow paths 11, 12 and 21, 22, thermoelectric conversion thermoelectric power generation can be performed by efficiently utilizing a temperature difference between the high and low temperature heat transfer media 2H and 2L.

## Description

### Technical Field

The invention relates to a technique of converting thermal energy into electrical energy using a thermoelectric element, and more specifically to a technique of generating electric power by utilizing a temperature difference that occurs in a thermal energy source such as a thermal engine and a heat pump.

### Background Art

It is known in the art to generate electric power by utilizing heat emitted from heat engines.

For example, a thermoelectric power generating module is known which is provided with a power generating layer having a thermoelectric converting element provided between an inner pipe and an outer pipe, and in which a high temperature heat transfer medium (hot water, steam, exhaust gas, etc.,) from a boiler or an internal combustion engine is introduced into the inner pipe to generate electric power with a temperature difference between the inner pipe and outer pipe (patent document 1).

According to the technique disclosed in patent document 1, since the temperature of the outer pipe which is in contact with ambient air is lower than the temperature of the inner pipe through which the high temperature heat transfer medium flows, electric power can be generated by thermoelectric conversion by utilizing a temperature difference between the inner and outer pipes.

### Document List

### Patent Document(s)

Patent Document 1: Japanese Laid-Open Patent Publication No. 9-36439 (Japanese Patent No. 2275410)

### Summary of Invention

### Technical Problem

However, with the technique disclosed in patent document 1, since thermoelectric conversion is performed by a power generating layer which is disposed in a sole layer of space between an inner cylinder and an outer cylinder, it is not possible to utilize a temperature difference that occurs in a thermal energy source efficiently in performing thermoelectric power generation. Further, the technique disclosed in patent document 1 has an essential drawback that power generation efficiency is not high, since thermoelectric conversion is performed with a relatively small temperature difference between a high temperature heat transfer medium and an ambient air.

It is an object of an aspect of the present disclosure to provide a thermoelectric power generating apparatus and a thermoelectric power generating method that can generate electric power by thermoelectric conversion by efficiently utilizing a temperature difference that occurs in a thermal energy source.

### Solution to Problem

### [Thermoelectric Power Generating Apparatus (Embodiment 1)]

A thermoelectric power generating apparatus of an aspect of the present disclosure includes:
a high temperature flow path through which a high temperature heat transfer medium flows;
a low temperature flow path through which a low temperature heat transfer medium having a lower temperature than the high temperature heat transfer medium flows; and
a power generating layer that generates electric power from a temperature difference,
the high temperature flow path and the low temperature flow path being each formed in a plurality of layers and alternately layered with each other with their centers in common,
the power generating layer being provided between the high temperature flow path and the low temperature flow path that are next to each other.

Such apparatus generates electric power by thermoelectric conversion with the power generating layer provided between the high temperature flow path and the low temperature flow path by causing the high temperature heat transfer medium to pass through the high temperature flow path and the low temperature heat transfer medium to pass through the low temperature flow path to produce a temperature difference between the high temperature flow path and the low temperature flow path.
The power generating layer in such apparatus constitutes a triple-layered (multi-layered) power generating layer sandwiched between the high temperature flow path and the low temperature flow path that are disposed alternately.
Therefore, with such an apparatus, by generating electric power by thermoelectric conversion with the power generating layer constituted by a plurality of layers (multiple layers), thermoelectric power generation can be performed utilizing a temperature difference produced in a thermal energy source much more efficiently than the related art.

In this thermoelectric power generating apparatus, the high temperature heat transfer medium is a compressed heat transfer medium in a heat pump (heat transfer medium between a compressor and an expansion valve), and the low temperature heat transfer medium is a decompressed heat transfer medium in the heat pump (heat transfer medium between an expansion valve and a compressor).

With this apparatus, by using a heat pump as a thermal energy source, thermoelectric power generation can be performed by extremely efficiently utilizing a temperature difference produced in a single system, which is the heat pump, in other words, a temperature difference between the compressed heat transfer medium and the decompressed heat transfer medium.

In this thermoelectric power generating apparatus,
it is desirable that the high temperature flow path and the low temperature flow path next to each other are partitioned with a double flow path walls constituted by inner and outer flow path walls that are spaced apart from each other,
the power generating layer having:
an inner electrode formed on an outer surface of an inner flow path wall;
an outer electrode formed on an inner surface of an outer flow path wall; and
a plurality of thermoelectric converting elements electrically connected between the inner electrode and the outer electrode and generating electric power with a temperature difference produced between both ends thereof.

### [Thermoelectric Power Generating Apparatus (Embodiment 2)]

A thermoelectric power generating apparatus of another aspect of the present disclosure includes:
a high temperature flow path through which a high temperature heat transfer medium (compressed heat transfer medium) in a heat pump flows;
a low temperature flow path through which a low temperature heat transfer medium (decompressed heat transfer medium) having a lower temperature than the high temperature heat transfer medium in the heat pump flows; and
a power generating layer that generates electric power from a temperature difference,
the high temperature flow path and the low temperature flow path being formed in an alternately layered manner,
the power generating layer being provided between the high temperature flow path and the low temperature flow path.
With this apparatus, thermoelectric power generation can be performed by using a heat pump as a thermal energy source. By using a plurality of power generating layers, a use efficiency of the thermal energy obtained from the heat pump can be improved. Accordingly, thermoelectric power generation can be performed with an improved efficiency by utilizing a temperature difference produced in a single system, which is the heat pump, in other words, a relatively large temperature difference between the compressed heat transfer medium and the decompressed heat transfer medium.

In this thermoelectric power generating apparatus,
it is desirable that the high temperature flow path and the low temperature flow path next to each other are partitioned with a double flow path walls constituted by inner and outer path walls spaced apart from each other,
the power generating layer having:
an inner electrode formed on an outer surface of an inner flow path wall;
an outer electrode formed on an inner surface of an outer flow path wall; and
a plurality of thermoelectric converting elements electrically connected between the inner electrode and the outer electrode and generating electric power with a temperature difference produced between both ends thereof.

### [Thermoelectric Power Generating Apparatus (Embodiment 3)]

An apparatus includes:
a high temperature flow path through which a high temperature heat transfer medium (compressed heat transfer medium) in a second heat pump flows, the second heat pump being in a heat pump system in which a heat radiation section of a first heat pump and an endothermic section of the second heat pump are thermally connected with each other;
a low temperature flow path through which a low temperature heat transfer medium (decompressed heat transfer medium) having a lower temperature than the high temperature heat transfer medium in the second heat pump flows; and
a power generating layer that generates electric power from a temperature difference,
the high temperature flow path and the low temperature flow path being formed in an alternately layered manner,
the power generating layer being provided between the high temperature flow path and the low temperature flow path.
This apparatus performs thermoelectric power generation using the second heat pump as a thermal energy source and by utilizing a temperature difference produced in the second heat pump, in other words, a temperature difference between a compressed heat transfer medium and a decompressed heat transfer medium. Since the endothermic section of the second heat pump is thermally in contact with the heat radiation section of the first heat pump, a greater temperature difference can be produced between the high temperature heat transfer medium and the low temperature heat transfer medium as compare to a case in which the second heat pump is operated independently.
Since this apparatus uses a plurality of power generating layers, a thermal energy obtained from the second heat pump can be used with an improved efficiency, and since a large temperature difference produced in the second heat pump can be utilized in thermoelectric conversion, thermoelectric power generation can be performed with an improved efficiency.

### [Thermoelectric Power Generating Method (Embodiment 1)]

A thermoelectric power generating method of an aspect of the present disclosure includes:
forming a high temperature flow path through which a high temperature heat transfer medium flows and a low temperature flow path through which a low temperature heat transfer medium having a lower temperature than the high temperature heat transfer medium flows, each formed in a plurality of layers, the high temperature flow path and the low temperature flow path being alternately layered with each other with their centers in common; and
generating electric power by providing a power generating layer that performs thermoelectric power generation from a temperature difference, the power generating layer being provided between the high temperature flow path and the low temperature flow path that are next to each other.

According to this method, power generation is performed by thermoelectric conversion with the power generating layer provided between the high temperature flow path and the low temperature flow path by causing the high temperature heat transfer medium to pass through the high temperature flow path and the low temperature heat transfer medium to pass through the low temperature flow path to produce a temperature difference between the high temperature flow path and the low temperature flow path.
The power generating layer used in this method constitutes a triple-layered layers (multi-layered) power generating layer sandwiched between the high temperature flow path and the low temperature flow path that are disposed alternately.
Therefore, with such an method, by generating electric power by thermoelectric conversion with the power generating layer constituted by a plurality of layers (multiple layers), thermoelectric power generation can be performed by utilizing a temperature difference produced in a thermal energy source much more efficiently than in the related art.

In this thermoelectric power generating method, the high temperature heat transfer medium is a compressed heat transfer medium in a heat pump (heat transfer medium from a compressor to an expansion valve), and the low temperature heat transfer medium is a decompressed heat transfer medium in the heat pump (heat transfer medium from an expansion valve to a compressor).
With such a method, by using a heat pump as a thermal energy source, thermoelectric power generation can be performed by extremely efficiently utilizing a temperature difference produced in a single system, which is the heat pump, in other words, a temperature difference between the compressed heat transfer medium and the decompressed heat transfer medium.

### [Thermoelectric Power Generating Method (Embodiment 2)]

A thermoelectric power generating method of another aspect of the present disclosure includes:
forming a high temperature flow path through which a high temperature heat transfer medium in a heat pump (compressed heat transfer medium) flows and a low temperature flow path through which a low temperature heat transfer medium (decompressed heat transfer medium) having a lower temperature than the high temperature heat transfer medium in the heat pump flows, the high temperature flow path and the low temperature flow path being alternately layered with each other with their centers in common; and
performing power generation by providing a power generating layer that performs thermoelectric power generation from a temperature difference, the power generating layer being provided between the high temperature flow path and the low temperature flow path.
With this method, using the heat pump as a thermal energy source, thermoelectric power generation can be performed with an increased efficiency by utilizing a temperature difference produced in a single system, which is the heat pump, in other words, a relatively large temperature difference between the compressed heat transfer medium and the decompressed heat transfer medium.

### [Thermoelectric Power Generating Method (Embodiment 3)]

A method includes:
forming a high temperature flow path through which a high temperature heat transfer medium (compressed heat transfer medium) in a second heat pump flows, the second heat pump being in a heat pump system in which a heat radiation section of a first heat pump and an endothermic section of the second heat pump are thermally connected with each other, and a low temperature flow path through which a low temperature heat transfer medium (decompressed heat transfer medium) having a lower temperature than the high temperature heat transfer medium in the second heat pump flows, in an alternately layered manner; and
generating electric power by a power generating layer that performs thermoelectric power generation, the power generating layer being provided between the high temperature flow path and the low temperature flow path.
According to this method, thermoelectric power generation is performed by using the second heat pump as a thermal energy source and utilizing a temperature difference produced in the second heat pump, in other words, a temperature difference between a compressed heat transfer medium and a decompressed heat transfer medium. Since the endothermic section of the second heat pump is thermally in contact with the heat radiation section of the first heat pump, a greater temperature difference can be produced between the high temperature heat transfer medium and the low temperature heat transfer medium as compare to a case in which the second heat pump is operated independently.
Accordingly, with this method, using the second heat pump as a thermal energy source, thermoelectric power generation can be performed with an increased efficiency by utilizing a large temperature difference produced in a single system, which is the second heat pump.

### Effect of the invention

According to an aspect of the present disclosure, thermoelectric power generation can be performed with an increased efficiency by utilizing a temperature difference produced in a single system that serves as a thermal energy source.

### Brief Description of Drawings

FIG. 1A is a cross-sectional diagram illustrating an embodiment of the present disclosure.
FIG. 1B is a cross-sectional diagram taken along B-B in FIG. A.
FIG. 2 is a cross-sectional diagram illustrating another embodiment of the present disclosure.
FIG. 3 is a cross-sectional diagram illustrating still another embodiment of the present disclosure.

### Description of the Embodiments

Hereinafter, embodiments of the invention will be described with reference to the attached drawings.

### [First Embodiment]

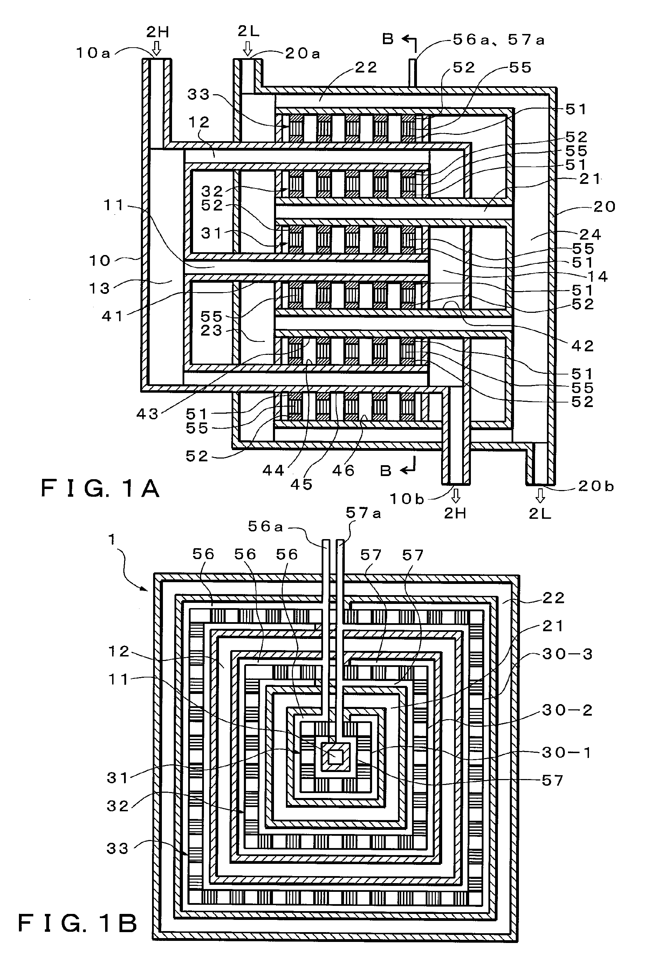

A thermoelectric power generating apparatus 1 shown in FIGS. 1A and 1B includes a first flow path body 10 through which a high temperature heat transfer medium 2H passes, a second flow path body 20 through which a low temperature heat transfer medium 2L passes, and first to third power generating layers 30-1, 30-2 and 30-3 that generate an electric power from a temperature difference.

The first flow path body 10 is a pipe body made of an electrically insulating material. The first flow path body 10 has an inlet 10a through which the high temperature heat transfer medium 2H flows in, an outlet 10b through which the high temperature heat transfer medium 2H flows out, first and second high temperature flow paths 11 and 12, a branching portion 13 that branches the high temperature heat transfer medium 2H which has flowed in through the inlet 10a into the first and second high temperature flow paths 11 and 12, and a merging portion 14 that causes the high temperature heat transfer medium 2H which has passed through the first and second high temperature flow paths 11 and 12 and guides to the outlet 10b.

The first high temperature flow path (inner high temperature flow path) 11 is a linear flow path having a square cross section in a direction perpendicular to a direction of flow of the heat transfer medium 2H.

The second high temperature flow path (outer high temperature flow path) 12 is formed outside the first high temperature flow path 11 with their centers in common. The second high temperature flow path 12 is a flow path having a square ring-like cross section with its diagonal directions being matched with those of the first high temperature flow path 11.

The second flow path body 20 is a pipe body made of an electrically insulating material. The first flow path body 20 has an inlet 20a through which the low temperature heat transfer medium 2L flows in, an outlet 20b through which the low temperature heat transfer medium 2L flows out, first and second low temperature flow paths 21 and 22, a branching portion 23 that branches the low temperature heat transfer medium 2L which has flowed in through the inlet 20a into the first and second low temperature flow paths 21 and 22, and a merging portion 24 that causes the low temperature heat transfer medium 2L which has passed through the first and second low temperature flow paths 21 and 22 to merge and be guided to the outlet 20b.

The first low temperature flow path (inner low temperature flow path) 21 is a ring-like flow path having a square ring-like cross section in a direction perpendicular to a direction of flow of heat transfer medium 2L. The first low temperature flow path 21 is formed at a middle position between the first high temperature flow path 11 and the second high temperature flow path 12 with its diagonal directions being matched with those of the flow paths 11 and 12.

The second low temperature flow path (outer low temperature flow path) 22 is formed outside the first low temperature flow path 21 with their centers in common. The second low temperature flow path 22 is a flow path having a square ring-like cross section with its diagonal directions being matched with those of the first low temperature flow path 21. The second low temperature flow path 22 is formed outside the second high temperature flow path 12 with its diagonal directions being matched with those of the flow path 12.

The first power generating layer 30-1 includes an inner electrode 51 formed on an outer surface of a flow path wall 41 of the first high temperature flow path 11, an outer electrode 52 formed on an inner surface of an inner flow path wall 42 partitioning the first low temperature flow path 21, and a plurality of thermoelectric converting elements 55 electrically connected between the inner electrode 51 and the outer electrode 52 and generating electric power with a temperature difference produced between both ends thereof.

The second power generating layer 30-2 includes an inner electrode 51 formed on an outer surface of an outer flow path wall 43 partitioning the first low temperature flow path 21, an outer electrode 52 formed on an inner surface of an inner flow path wall 44 partitioning the second high temperature flow path 12, and a plurality of thermoelectric converting elements 55 electrically connected between the inner electrode 51 and the outer electrode 52 and generating electric power with a temperature difference produced between both ends thereof.

The third power generating layer 30-3 includes an inner electrode 51 formed on an outer surface of an outer flow path wall 45 partitioning the second high temperature flow path 12, an outer electrode 52 formed on an inner surface of an inner flow path wall 46 partitioning the second low temperature flow path 22 and a plurality of thermoelectric converting elements 55 electrically connected between the inner electrode 51 and the outer electrode 52 and generating electric power with a temperature difference produced between both ends thereof.

The inner electrode 51 and the outer electrode 52 of each of the first to third power generating layers 30-1, 30-2 and 30-3 are electrically connected with each other by electric wirings 56 and 57, respectively. A pair of output terminals 56a and 57a extending from each electric wiring 56, 57 is provided outside the second flow path body 20. Electric power generated by the first to third power generating layers 30-1, 30-2 and 30-3 is collectively output from a pair of output terminals 56a and 57a.

In the first to third power generating layers 30-1, 30-2 and 30-3, the inner electrode 51 and the outer electrode 52 with the thermoelectric converting element 55 may be connected with any connecting method. Any of the configurations, such as a configuration in which all the thermoelectric converting elements 55 are electrically connected in parallel with each other, all the thermoelectric converting elements 55 are electrically connected in a series, and a series-parallel connection in which a series connection and a parallel connection are combined.

The thermoelectric power generating apparatus 1 of the first embodiment configured as described above generates electric power by thermoelectric conversion using the power generating layers 30-1, 30-2 and 30-3 provided between the high temperature flow paths 11, 12 and the low temperature flow paths 21, 22 by causing the high temperature heat transfer medium 2H to flow through the first flow path body 10 and the low temperature heat transfer medium 2L flow through the second flow path body 12, respectively, and producing a temperature difference between the high temperature flow paths 11, 12 of the first flow path body 10 and the low temperature flow paths 21, 22 of the second flow path body 12, 22.

With such thermoelectric power generating apparatus 1, since electric power generation by thermoelectric conversion is performed by the three power generating layers 30-1, 30-2 and 30-3 that are sandwiched between the high temperature flow paths 11, 12 and the low temperature flow paths 21, 22, which are disposed alternately, thermoelectric power generation can be performed by efficiently utilizing the temperature difference between the high temperature heat transfer medium 2H and the low temperature heat transfer medium 2L.

This thermoelectric power generating apparatus 1 may utilize a heat pump as the thermal energy source. That is, a compressed heat transfer medium (a heat transfer medium between a compressor and an expansion valve) in the heat pump is used as the high temperature heat transfer medium 2H and a decompressed heat transfer medium (a heat transfer medium between an expansion valve and a compressor) in the heat pump is used as a low temperature heat transfer medium 2L.

With the thermoelectric power generating apparatus 1, a use efficiency of the thermal energy can be increased by using the three power generating layers 30-1, 30-2 and 30-3, and thermoelectric power generation can be performed by extremely efficiently utilizing a temperature difference produced in a single system, which is a heat pump, in other words a relatively large temperature difference between a compressed heat transfer medium (high temperature heat transfer medium 2H) and a decompressed heat transfer medium (low temperature heat transfer medium 2L).

Note that, in the aforementioned example, a configuration of the apparatus having a triple-layered power generating layer, but any number of layers of power generating layer may be provided. A thermoelectric power generating apparatus having a double-layered power generating layer and thermoelectric power generating apparatuses having four or more power generating layers are within the scope of the present disclosure.

Also, in the aforementioned embodiment, the cross section of the first high temperature flow path 11 is square shaped and the cross section of other flow paths 12, 21 and 22 is a square annular cross section, but the shape of the cross section of the flow path is not limited to a square. The shape may be rectangular or circular.

### [Second Embodiment]

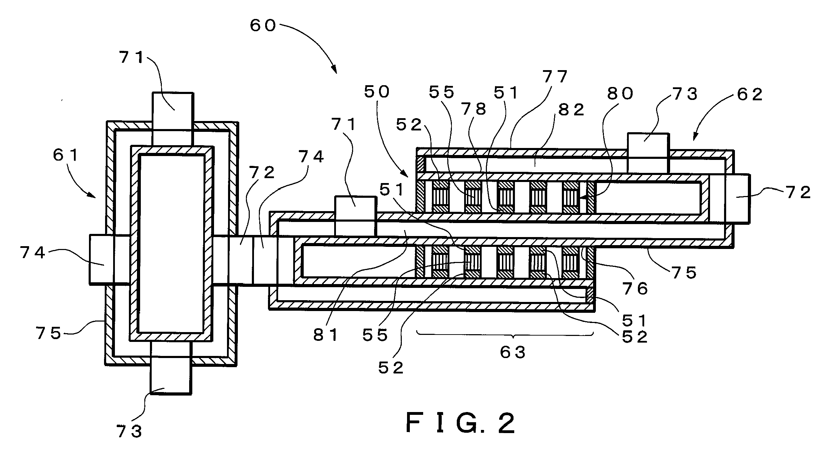

FIG. 2 shows an embodiment in which a thermoelectric power generating apparatus 50 of the present disclosure is integrated with a heat pump system 60. The heat pump system 60 has two systems of heat pumps 61 and 62. Each system of the heat pump 61, 62 is generally constituted by a compressor 71, a heat radiation section 72, an expansion valve 73 and endothermic section 74 that are connected in a loop with a refrigerant pipe 75. The heat radiation section 72 of one heat pump (first heat pump) 61 and an endothermic section 74 of another heat pump (second heat pump) 62 are thermally connected with each other.

The refrigerant pipe 75 of the second heat pump 62 has a triple-layered pipe structured portion 63 constituted by an inner pipe 76, an outer pipe 77 provided outside the inner pipe 76 with their centers in common, and an intermediate pipe 78 disposed between the inner pipe 76 and the outer pipe 77 with their centers in common. An interior of the inner pipe 76 forms a high temperature flow path 81 through which a refrigerant (high temperature heat transfer medium) 2H compressed by the compressor 71 passes. A space between the outer pipe 77 and the intermediate pipe 78 forms a low temperature flow path 82 through which a refrigerant (low temperature heat transfer medium) 2L expanded by the expansion valve 73 passes. A power generating layer 80 that generates electric power by a temperature difference is provided between the inner pipe 76 and the intermediate pipe 78 of the triple-layered pipe structured portion 63.

The power generating layer 80 has an inner electrode 51 formed on an outer surface of the inner pipe (flow path wall) 76, an outer electrode 52 formed on an inner surface of the intermediate pipe (flow path wall) 78, and a plurality of thermoelectric converting elements 55 electrically connected between the inner electrode 51 and the outer electrode 52 and generating electric power from a temperature difference produced between both ends thereof. The inner electrodes 51 are electrically connected to each other and the outer electrodes 52 are electrically connected to each other by respective electric wirings, not shown. An output terminal, not shown, is drawn out from each of the electric wirings to an exterior of the outer pipe 77.

The thermoelectric power generating apparatus 50 that is configured as described above performs thermoelectric power generation using the second heat pump 62 as a thermal energy source and by utilizing a temperature difference produced in a single system, which is the second heat pump 62, in other words, a temperature difference between a compressed heat transfer medium (high temperature heat transfer medium 2H) and a decompressed heat transfer medium (low temperature heat transfer medium 2L). Since the second heat pump 62 is configured in such a manner that its endothermic section 74 is thermally in contact with the heat radiation section 72 of the first heat pump 62, a greater temperature difference can be produced between the high temperature heat transfer medium 2H and the low temperature heat transfer medium 2L as compared to a case where the second heat pump 62 is operated independently.

Therefore, although this thermoelectric power generating apparatus 50 has a single layer of power generating layer 80 only, since a greater temperature difference that occurs in the second heat pump 62 can be utilized in thermoelectric conversion, a highly efficient thermoelectric power generation can be achieved.

By thermally connecting more than three systems of heat pumps in a multistage and incorporating the thermoelectric power generating apparatus 50 into the heat pump of the last stage, i.e., the heat pump that finally receives heat from the heat radiation section of the heat pump provided upstream thereof, a thermoelectric power generation of an even higher efficiency can be achieved by utilizing a greater temperature difference produced in the heat pump of the last stage.

### [Third Embodiment]

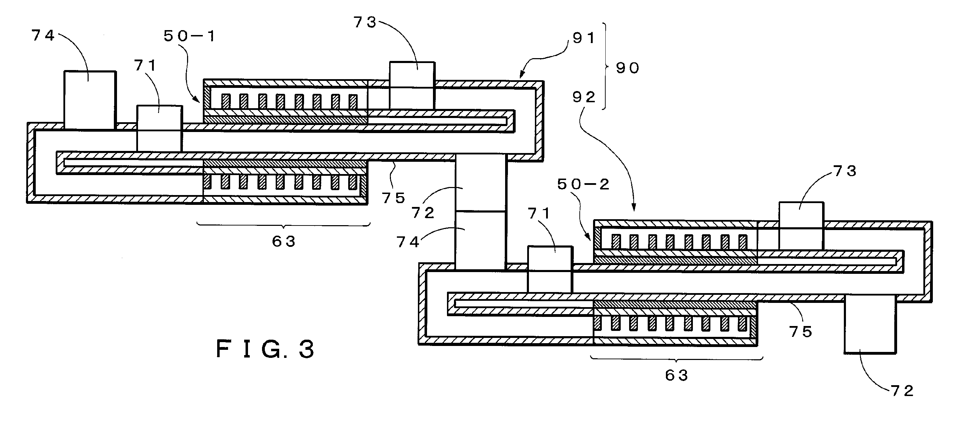

FIG. 3 shows an exemplary configuration of a thermoelectric power generation power generation system that uses a heat pump system 90 including two systems of heat pumps 91 and 92 as a thermal energy source. Each of the heat pumps 91 and 92 has the same configuration as the second heat pump 82 shown in FIG. 2, and a thermoelectric power generating apparatuses 50 (50-1, 50-2) are provided integrally with each of the heat pumps 91 and 92, respectively. The heat radiation section 72 of the first heat pump 91 and the endothermic section 74 of the second heat pump 92 are thermally connected with each other.

According to the thermoelectric power generating system described above, thermoelectric power generation utilizing a temperature difference produced in the second heat pump 92 and thermoelectric power generation utilizing a temperature difference produced in the first heat pump 91 can be performed at the same time. Since the temperature difference produced in the first heat pump 91 is less than the temperature difference produced in the second heat pump 92, power generating efficiency of the thermoelectric power generating apparatus 50-1 provided in the first heat pump 91 is less than power generating efficiency of the thermoelectric power generating apparatus 50-2 provided in the second heat pump 92. However, by using both thermoelectric power generating apparatuses 50-1 and 50-2, a significantly large power generation capacity can be achieved as compared to a case where only the thermoelectric power generating apparatus 50-2 provided in the second heat pump 92 is used.

Even greater power generating capacity can be achieved by constituting a power generating system by thermally connecting more than three systems of heat pumps in a multistage and incorporating the thermoelectric power generating apparatus 50 to the heat pump in each stage.

### [Fourth Embodiment]

In the second and third embodiments, the thermoelectric power generating apparatus 1 of the first embodiment is used in place of the thermoelectric power generating apparatuses 50 (50-1, 50-2).
With such a structure, since a use efficiency of a thermal energy can be increased by using three layers of power generating layers 30-1, 30-2 and 30-3, thermoelectric power generation can be performed extremely efficiently by utilizing a large temperature difference produced in the heat pump system that is constituted by thermally connecting a plural of systems of heat pumps.

### Industrial applicability

The thermoelectric power generating apparatus and the thermoelectric power generating method of the present disclosure are applicable in saving energy in various electric appliances having a high temperature section and a low temperature section (a section having a temperature lower than that of the high temperature section) therein. For example, by applying this to electric appliances that uses a heat pump such as air conditioners, hot-water supply systems, and washing machines, electric power can be generated efficiently by utilizing a temperature difference produced in the heat pump in the appliances. By utilizing the electric power thus-obtained by power generation, appliances with extremely high energy efficiency can be obtained.

Further, the thermoelectric power generating apparatus of the present disclosure may be modularized in such a manner that it can be mounted to the piping of an existing heat pump. With such a structure, by mounting this in a retrofitting manner to an electric appliance that uses a heat pump, energy efficiency of the electric appliance can be improved.

The thermoelectric power generating apparatus and the thermoelectric power generating method of the present disclosure can generate electric power employing a system that uses high temperature steam for power generation, such as a nuclear power plant, thermal power plant, and geothermal power plant, as a thermal energy source. For example, when utilizing the nuclear power plant as a thermal energy source, by causing the high temperature steam which has passed through a turbine to pass through the high temperature flow path as a high temperature heat transfer medium and causing seawater to pass through the low temperature flow path as a low temperature heat transfer medium, thermoelectric power generation can be performed by utilizing a large temperature difference between the two. Also, high temperature steam heated by decay heat from a fuel can be used as a high temperature heat transfer medium. Therefore, thermoelectric power generation can also be performed in a reactor shutdown state.

Further, a thermoelectric power generating apparatus and the thermoelectric power generating method of the present disclosure can generate electric power by utilizing a data center as a thermal energy source. In other words, by causing air that has been heated by heat generated in a server or a storage in the data center pass through the high temperature flow path as a high temperature heat transfer medium, and causing water (seawater, ground water, river water, etc) and ambient air pass through the low temperature flow path as a low temperature heat transfer medium, thermoelectric power generation can be performed by utilizing a temperature difference between the two. By consuming electric power obtained by this thermoelectric power generation in a data center, energy savings in the data center can be promoted.

**List of Reference Signs**

| | |
|---|---|
| 1 | thermoelectric power generating apparatus |
| 2H | high temperature heat transfer medium |
| 2L | low temperature heat transfer medium |
| 10 | first flow path body |
| 11 | first high temperature flow path |
| 12 | second high temperature flow path |
| 20 | second flow path body |
| 21 | first low temperature flow path |
| 22 | second low temperature flow path |
| 30-1 | first power generating layer |
| 30-2 | second power generating layer |
| 30-3 | third power generating layer |
| 41 | flow path wall |
| 42 | flow path wall |
| 43 | flow path wall |
| 44 | flow path wall |
| 45 | flow path wall |
| 46 | flow path wall |
| 51 | inner electrode |
| 52 | outer electrode |
| 55 | thermoelectric converting element |
| 56 | wiring |
| 57 | wiring |
| 60 | heat pump system |
| 61 | first heat pump |
| 62 | second heat pump |
| 80 | power generating layer |
| 90 | heat pump system |
| 91 | first heat pump |
| 92 | second heat pump |

## Claims

1. A thermoelectric power generating apparatus comprising:
a high temperature flow path through which a high temperature heat transfer medium flows;
a low temperature flow path through which a low temperature heat transfer medium having a lower temperature than the high temperature heat transfer medium flows; and
a power generating layer that generates electric power from a temperature difference,
the high temperature flow path and the low temperature flow path being each formed in a plurality of layers and alternately layered with each other with their centers in common,
the power generating layer being provided between the high temperature flow path and the low temperature flow path that are next to each other.

2. The thermoelectric power generating apparatus according to claim 1, wherein the high temperature heat transfer medium is a compressed heat transfer medium in a heat pump, and the low temperature heat transfer medium is a decompressed heat transfer medium in the heat pump.

3. A thermoelectric power generating apparatus comprising:
a high temperature flow path through which a high temperature heat transfer medium in a heat pump flows;
a low temperature flow path through which a low temperature heat transfer medium having a lower temperature than the high temperature heat transfer medium in the heat pump flows; and
a power generating layer that generates electric power from a temperature difference,
the high temperature flow path and the low temperature flow path being alternately layered with each other,
the power generating layer being provided between the high temperature flow path and the low temperature flow path.

4. A thermoelectric power generating method, comprising:
forming a high temperature flow path through which a high temperature heat transfer medium flows and a low temperature flow path through which a low temperature heat transfer medium having a lower temperature than the high temperature heat transfer medium flows, each formed in a plurality of layers, the high temperature flow path and the low temperature flow path being alternately layered with each other with their centers in common; and
generating electric power by providing a power generating layer that performs thermoelectric power generation from a temperature difference, the power generating layer being disposed between the high temperature flow path and the low temperature flow path that are next to each other.

5. The thermoelectric power generating method according to claim 4, wherein the high temperature heat transfer medium is a compressed heat transfer medium in a heat pump, and the low temperature heat transfer medium is a decompressed heat transfer medium in the heat pump.

6. A thermoelectric power generating method, comprising:
forming a high temperature flow path through which a high temperature heat transfer medium in a heat pump flows and a low temperature flow path through which a low temperature heat transfer medium having a lower temperature than the high temperature heat transfer medium in the heat pump flows, the high temperature flow path and the low temperature flow path being alternately layered with each other with their centers in common; and
performing power generation by providing a power generating layer that performs thermoelectric power generation from a temperature difference, the power generating layer being disposed between the high temperature flow path and the low temperature flow path.
